# EUROPÄISCHE PATENTSCHRIFT

(11) **EP 0 856 738 B1**
(45) Veröffentlichungstag und Bekanntmachung des Hinweises auf die Patenterteilung: **02.01.2002**
(21) Anmeldenummer: 97118588.9
(22) Anmeldetag: 25.10.1997
(51) Int. Cl.: G01R 22/00, H02J 7/35

(54) **Extern gespeiste Anordnung mit einer elektronischen Anzeige und/oder einer Kommunikations-Schnittstelle**
Externally powered device with an electronic display and/or a communication interface
Appareil alimenté par l'extérieur avec affichage électronique ou/et interface de communication

(30) Priorität: 31.01.1997 CH 20297
(43) Veröffentlichungstag der Anmeldung: 05.08.1998
(73) Patentinhaber: Siemens Metering AG, 6300 Zug (CH)
(72) Erfinder: Thürig, Andreas, 6330 Cham (CH); Berner, Gerhard, 6300 Zug (CH); Ricciardi, Bruno, 6030 Ebikon (CH)
(74) Vertreter: Zedlitz, Peter, Dipl.-Inf.

(56) Entgegenhaltungen:
- DE-A- 4 139 011
- DE-C- 4 107 452
- GB-A- 2 017 937
- US-A- 5 185 700

## Beschreibung

Die Erfindung bezieht sich auf eine extern gespeiste Anordnung mit einer elektronischen Anzeige und/oder einer Kommunikations-Schnittstelle gemäss dem Oberbegriff des Anspruchs 1.

Die Anordnung ist ein beliebiges Mess-, Tarif- oder Registriergerät, vorzugsweise jedoch ein Gas-, Wasser- oder Energie-Verbrauchsmessgerät, wie z. B. ein elektronischer Elektrizitätszähler. Die Anordnung besitzt eine elektronische Anzeige, welche gemessene, berechnete und/oder sonstige variable Parameterwerte anzeigt. Bei Elektrizitätszählern sind die gemessenen Parameterwerte z. B. Energie-, Leistungs-, Spannungs- oder Stromwerte, während als sonstiger variabler Parameterwert z. B. eine Kundennummer vorhanden ist, die von Elektrizitätszähler zu Elektrizitätszähler unterschiedlich ist. Die Parameterwerte sind in einem Speicher der Anordnung gespeichert und können auch - ergänzend zur Anzeige oder auch anstelle der Anzeige - über eine Kommunikations-Schnittstelle nach aussen hin, z. B. zur Fernablesung, übertragen werden.

Im Betrieb wird die Anordnung in der Regel von einem elektrischen Versorgungsnetz mit Energie gespeist. In gewissen Fällen, z. B. bei einem Netzausfall, auf Baustellen, in einem Saisonbetrieb, in Lokomotiven mit eingezogenem Stromabnehmer oder während der Lagerung, ist das elektrische Versorgungsnetz noch nicht angeschlossen oder noch nicht eingeschaltet, so dass die elektronische Anzeige und die Kommunikations-Schnittstelle relativ wertlos sind, da für ihre Lesbarkeit bzw. Betrieb elektrische Energie erforderlich ist. In all diesen Fällen sind die gespeicherten Parameterwerte somit erst lesbar, wenn die Anordnung vom elektrischen Versorgungsnetz mit Energie versorgt wird. Dies im Gegensatz zu Anordnungen, die mit einem mechanischen Zählwerk ausgerüstet sind, bei denen in all den oben genannten Fällen (Netzausfall, Baustelle, Saisonbetrieb, Lokomotive, Lagerung) der angezeigte Parameterwert ohne weiteres lesbar ist, da für eine mechanische Anzeige und deren Lesen bekanntlich keine elektrische Energieversorgung erforderlich ist.

Die Verwendung von Batterien ist in solchen, in der Regel in einem Langzeitbetrieb, z. B. während 10 Jahre betriebenen Anordnungen unüblich und - wegen einer möglichen Entladung der Batterien-im Laufe der Zeit mit Schwierigkeiten verbunden. Auch ist es aus dem gleichen Grund wenig sinnvoll, die Anordnung schon während der Lagerhaltung mit einer Batterie zu bestücken.

Ein mit einer Solarzelle ausgerüsteter elektronischer Elektrizitätszähler ist aus der US-A-5,197,291 bekannt, in dem die Elektronik von einer Batterie gespeist ist, welche zur Sicherstellung der Batterieleistung bei Sonneneinstrahlung von einem Kühlaggregat gekühlt ist, welches von einer Solarzelle gespeist wird.

Der Erfindung liegt die Aufgabe zugrunde, eine Anordnung der eingangs genannten Art zu verwirklichen, deren Speicherinhalt - von nah und/oder fern - ohne vorhandene Netzspannung, ohne vorhandene Batterie, ohne lästige Anschlüsse einer externen Spannungsquelle und ohne Zerstörung von Sicherheits-Plomben mindestens teilweise lesbar und/oder parametrierbar ist, letzteres z. B. zur Vorbereitung einer Inbetriebnahme. Sicherheits-Plomben schützen bekanntlich Elektrizitätszähler gegen unerlaubte Manipulationen. Dabei verhindert ein plombierter Deckel, dass, ohne Zerstörung der Sicherheits-Plombe, der Elektrizitätszähler für eine direkte Speisung von aussen zugänglich ist.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

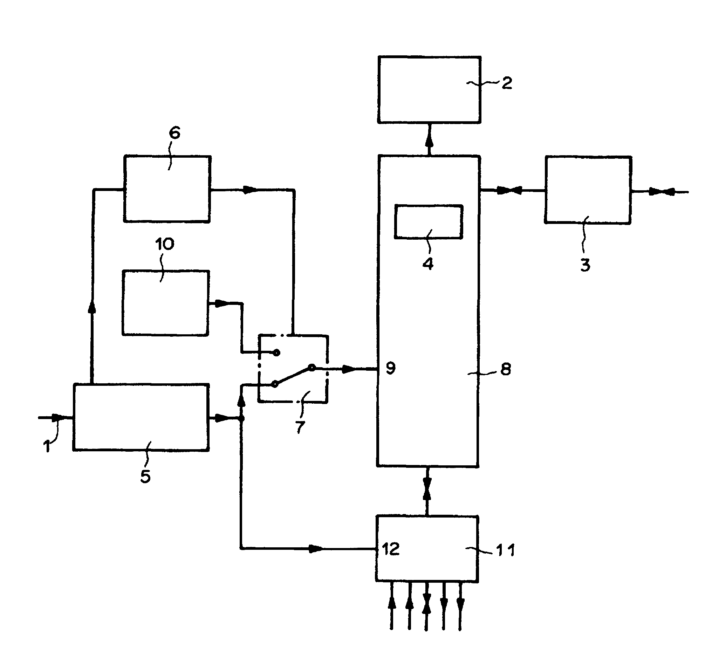

Ein Ausführungsbeispiel der Erfindung ist in der einzigen Figur der Zeichnung dargestellt und wird im folgenden näher beschrieben.

Die in der Figur dargestellte erfindungsgemässe Anordnung ist von aussen mit einer elektrischen Speisespannung 1 versorgt. Sie ist ausserdem versehen mit einer elektronischen Anzeige 2 und/oder einer Kommunikations-Schnittstelle 3 zum Lesen und/oder Schreiben eines Inhaltes eines Speichers 4. In der Figur gilt die Annahme, dass sowohl die Anzeige 2 als auch die Kommunikations-Schnittstelle 3 vorhanden sind. Die Speisespannung 1 ist eine Wechselspannung und speist ein Speisegerät 5, in dem die Wechselspannung in eine oder mehrere Gleichspannungen umgewandelt wird, wovon mindestens eine einer Spannungsüberwachung 6 zugeführt wird. Die letztere überwacht über die Gleichspannung mittelbar das Vorhanden- oder Nichtvorhandensein der Speisespannung 1 und schaltet bei einem Nichtvorhandensein derselben einen Umschalter 7 um, dessen Steuereingang, falls vorhanden, mit einem Ausgang der Spannungsüberwachung 6 verbunden ist. Der Speicher 4 besitzt eine Schreib/Lese-Elektronik 8. Bei abwesender Speisespannung 1 schaltet der Umschalter 7 einen Eingang 9 der Schreib/Lese-Elektronik 8 um von einem Ausgang des Speisegerätes 5 auf einen Ausgang einer Einrichtung 10 zum kontaktlosen Speisen mit Energie eines Teils 2;3;8 der Anordnung, welches mindestens aus der elektronischen Anzeige 2 und/oder der Kommunikations-Schnittstelle 3 sowie der Schreib/Lese-Elektronik 8 des Speichers 4 besteht. Die Elektronik 11 enthält all jene Elektronik und all jene Funktionen, die nicht zum Lesen und/oder Schreiben des Speichers 4 erforderlich sind. Der Ausgang des Speisegerätes 5 ist mit einem Speiseeingang 12 der Elektronik 11 verbunden, so dass diese bei vorhandener Speisespannung 1 ausschliesslich vom Speisegerät 5 gespeist wird, welches in diesem Fall über den Umschalter 7 auch den Teil 2;3;8 der Anordnung mit Energie speist. Die Elektronik 11 wird dagegen nie von der Einrichtung 10 mit Energie gespeist. Mit anderen Worten: Im Normalbetrieb wird die ganze Anordnung, also auch die Elektronik 8 und 11, automatisch von der Speisespannung 1 über das Speisegerät 5 mit Energie versorgt. Ist aus irgend einen Grund die Speisespannung 1 nicht vorhanden, wird die Anordnung automatisch von der Spannungsüberwachung 6 mit Hilfe des Umschalters 7 in einen Energie-Sparmodus geschaltet, bei dem der Energieverbrauch der Anordnung auf ein Minimum reduziert wird. In diesem Fall erfolgt ausschliesslich die Speisung der elektronischen Anzeige 2, der Kommunikations-Schnittstelle 3 und der Schreib/Lese-Elektronik 8 von der Einrichtung 10 aus, falls diese von aussen kontaktlos mit Energie versorgt wird, während die Elektronik 11 zum Energiesparen überhaupt nicht mit Energie versorgt wird und somit ausser Betrieb ist. In einer bevorzugten Ausführung der Erfindung wird zur Reduktion des Energieverbrauchs ausserdem noch die Frequenz des Taktsignals ("clock") sehr stark reduziert, da bei niedriger Frequenz der Energieverbrauch des in Betrieb verbleibenden und in der Regel in CMOS-Technologie hergestellten Teils 2;3;8 der Anordnung viel niedriger ist als bei der höheren, im Normalbetrieb verwendeten Taktfrequenz. Anders ausgedrückt: Bei abwesender Speisespannung 1 wird mindestens die elektronische Anzeige 2 und/oder die Kommunikations-Schnittstelle 3 sowie die Schreib/Lese-Elektronik 8 des Speichers 4 mittels der Spannungsüberwachung 6 und des Umschalters 7 in einen Niedrigenergieverbrauchs-Modus geschaltet, welcher auch als "low power mode" bekannt ist.

In der Figur ist der Umschalter 7 als elektromechanischer Umschalter dargestellt. Es ist jedoch wohlverstanden, dass er auch ein mittels Transistoren oder sogenannten "transmission gates" aufgebauter Halbleiter-Umschalter sein kann. Er kann auch z. B. aus zwei Dioden bestehen, die in einer Oder-Schaltung miteinander verknüpft sind, wobei die beiden miteinander verbundenen Kathoden der Dioden einen Ausgang des Umschalters 7 bilden, der auf den Eingang 9 der Schreib/Lese-Elektronik 8 geführt ist, während die Anode der beiden Dioden jeweils mit dem Ausgang des Speisegerätes 5 bzw. der Einrichtung 10 verbunden ist. In diesem Fall besitzt der Umschalter 7 keinen Steuereingang.

In einer ersten Variante der erfindungsgemässen Anordnung ist die Einrichtung 10 eine Solarzelle mit oder ohne Pufferspeicher. In dieser Variante werden bei abwesender Speisespannung 1 mindestens die elektronische Anzeige 2 und/oder die Kommunikations-Schnittstelle 3 sowie die Schreib/Lese-Elektronik 8 des Speichers 4 von aussen kontaktlos mittels der Solarzelle mit Energie gespeist, wenn die Solarzelle beleuchtet ist. Letzteres kann im Extremfall mittels einer Taschenlampe erfolgen. Die Speiseenergie wird also in dieser Variante kontaktlos mittels Licht zugeführt und bei beleuchteter Solarzelle kann der Inhalt des Speichers 4 mittels der elektronischen Anzeige 2 vor Ort und/oder mittels der Kommunikations-Schnittstelle 3 aus der Ferne gelesen werden. Auch ist mit beleuchteter Solarzelle von nah und/oder von fern ein Beschreiben oder ein Ändern des Inhaltes des Speichers 4 möglich, z. B, zwecks Neu- oder Umparametrierung der Anordnung.

In einer zweiten Variante der erfindungsgemässen Anordnung ist die Einrichtung 10 zum kontaktlosen Speisen mit Energie so ausgebildet, dass bei abwesender externer Speisespannung 1 mindestens die elektronische Anzeige 2 und/oder die Kommunikations-Schnittstelle 3 sowie die Schreib/Lese-Elektronik 8 des Speichers 4 von aussen induktiv kontaktlos mit Energie gespeist sind.

In einer dritten Variante der erfindungsgemässen Anordnung ist die Einrichtung 10 zum kontaktlosen Speisen mit Energie so ausgebildet, dass bei abwesender externer Speisespannung 1 mindestens die elektronische Anzeige 2 und/oder die Kommunikations-Schnittstelle 3 sowie die Schreib/Lese-Elektronik 8 des Speichers 4 von aussen kapazitiv kontaktlos mit Energie gespeist sind.

## Patentansprüche

1. Extern gespeiste Anordnung mit einer elektronischen Anzeige (2) und/oder einer Kommunikations-Schnittstelle (3) zum Lesen und/oder Schreiben eines Inhaltes eines Speichers (4), **dadurch gekennzeichnet, dass** bei abwesender externer Speisespannung (1) mindestens die elektronische Anzeige (2) und/oder die Kommunikations-Schnittstelle (3) sowie eine Schreib/Lese-Elektronik (8) des Speichers (4) von aussen kontaktlos mit Energie gespeist sind.

2. Extern gespeiste Anordnung nach Anspruch 1, **dadurch gekennzeichnet, dass** bei abwesender externer Speisespannung (1) mindestens die elektronische Anzeige (2) und/oder die Kommunikations-Schnittstelle (3) sowie die Schreib/Lese-Elektronik (8) des Speichers (4) von aussen kontaktlos mittels einer Solarzelle mit Energie gespeist sind.

3. Extern gespeiste Anordnung nach Anspruch 1, **dadurch gekennzeichnet, dass** bei abwesender externer Speisespannung (1) mindestens die elektronische Anzeige (2) und/oder die Kommunikations-Schnittstelle (3) sowie die Schreib/Lese-Elektronik (8) des Speichers (4) von aussen induktiv kontaktlos mit Energie gespeist sind.

4. Extern gespeiste Anordnung nach Anspruch 1, **dadurch gekennzeichnet, dass** bei abwesender externer Speisespannung (1) mindestens die elektronische Anzeige (2) und/oder die Kommunikations-Schnittstelle (3) sowie die Schreib/Lese-Elektronik (8) des Speichers (4) von aussen kapazitiv kontaktlos mit Energie gespeist sind.

5. Extern gespeiste Anordnung nach einem der Ansprüche 1 bis 4, **dadurch gekennzeichnet, dass** bei abwesender externer Speisespannung (1) mindestens die elektronische Anzeige (2) und/oder die Kommunikations-Schnittstelle (3) sowie die Schreib/Lese-Elektronik (8) des Speichers (4) in einen Niedrigenergieverbrauchs-Modus, einen sogenannten "low power mode", geschaltet ist.

## Claims

1. An externally fed arrangement with an electronic display (2) and/or a communication interface (3) for reading and/or writing a content of a memory (4), **characterised in that** when the external feed voltage (1) is absent at least the electronic display (2) and/or the communication interface (3) and a write/read electronic means (8) of the memory (4) are contact-lessly fed with power from the exterior.

2. An externally fed arrangement according to claim 1 **characterised in that** when the external feed voltage (1) is absent at least the electronic display (2) and/or the communication interface (3) and the write/read electronic means (8) of the memory (4) are contact-lessly fed with power from the exterior by means of a solar cell.

3. An externally fed arrangement according to claim 1 **characterised in that** when the external feed voltage (1) is absent at least the electronic display (2) and/or the communication interface (3) and the write/read electronic means (8) of the memory (4) are inductively contact-lessly fed with power from the exterior.

4. An externally fed arrangement according to claim 1 **characterised in that** when the external feed voltage (1) is absent at least the electronic display (2) and/or the communication interface (3) and the write/read electronic means (8) of the memory (4) are capacitively contact-lessly fed with power from the exterior.

5. An externally fed arrangement according to one of claims 1 to 4 **characterised in that** when the external feed voltage (1) is absent at least the electronic display (2) and/or the communication interface (3) and the write/read electronic means (8) of the memory (4) is switched into a low energy consumption mode, a socalled 'low power mode'.

## Revendications

1. Dispositif à alimentation externe, comportant un dispositif d'affichage électronique (2) et/ou une interface de communication (3) pour la lecture et/ou l'écriture d'un contenu d'une mémoire (4), **caractérisé en ce que** lorsque la tension d'alimentation externe (1) est absente, au moins le dispositif d'affichage électronique (2) et/ou l'interface de commnicaLion (3) et des moyens électroniques d'écriture/de lecture (8) de la mémoire (4) sont alimentés en énergie sans contact à partir de l'extérieur.

2. Dispositif à alimentation externe, selon la revendication 1, **caractérisé en ce que** lorsque la tension d'alimentation externe (1) est absente, au moins le dispositif d'affichage électronique (2) et/ou l'interface de commnication (3) et les moyens électroniques d'écriture/lecture (8) de la mémoire (4) sont alimentés en énergie sans contact de l'extérieur au moyen d'une pile solaire.

3. Dispositif à alimentation externe selon la revendication 1, **caractérisé en ce que** la lorsque la tension d'alimentation externe (1) est absente, au moins le dispositif d'affichage électronique (2) et/ou l'interface de commnication (3) et les moyens électroniques d'écriture/lecture (8) de la mémoire (4) sont alimentés en énergie inductivement sans contact à partir de l'extérieur.

4. Dispositif à alimentation externe selon la revendication 1, **caractérisé en ce que** lorsque la tension d'alimentation externe (1) est absente, au moins le dispositif d'affichage électronique (2) et/ou l'interface de communication (3) et les moyens électroniques d'écriture/lecture (8) de la mémoire (4) sont alimentés en énergie de façon capacitive sans contact à partir de l'extérieur.

5. Dispositif à alimentation externe selon l'une des revendications 1 à 4, **caractérisé en ce que**, lorsque la tension d'alimentation externe (1) est absente, au moins le dispositif d'affichage électronique (2) et/ou l'interface de communication (3) et les moyens électroniques d'écriture/lecture (8) de la mémoire (4) sont commutés sur un mode d'alimentation de faible énergie, ce qu'on appelle un "low power mode".
